# EUROPEAN PATENT SPECIFICATION

(11) **EP 0 247 942 B1**
(45) Date of publication and mention of the grant of the patent: **02.02.1994**
(21) Application number: 87401187.7
(22) Date of filing: 26.05.1987
(51) Int. Cl.: H01L 27/14, H01L 21/82

(54) **Semiconductor image sensor and a method for fabricating same**
Halbleiterbildsensor und Herstellungsverfahren dafür
Capteur d'images semi-conducteur et son procédé de fabrication

(30) Priority: 26.05.1986 JP 119347/86
(43) Date of publication of application: 02.12.1987
(73) Proprietor: FUJITSU LIMITED, Kawasaki-shi, Kanagawa 211 (JP)
(72) Inventor: Takei, Akira 5-401, 150-4, Hitorizawacho, Yokohama-shi Kanagawa 235 (JP); Nishikawa, Tetsuo Dai-7-Nakahararyo, 528, Kawasaki-shi Kanagawa 211 (JP)
(74) Representative: Joly, Jean-Jacques

(56) References cited:
- US-A- 4 378 565
- TRANSACTIONS OF THE INSTITUTE OF ELECTRONICS AND COMMUNICATION vol. E63, no. 12, December 1980, TOKYO JP pages 855 - 862; T. WATANABE et al.: "CCD LINEAR IMAGE SENSOR WITH 2 048 ELEMENTS"
- IEEE TRANSACTIONS ON ELECTRON DEVICES. vol. ED-32, no. 8, August 1985, NEW YORK US pages 1551 - 1558; G. J. DECLERCK et al.: "THE DEPLI SENSOR: A NEW STRUCTURE FOR VERY-HIGH-RESOLUTION IMAGERS"

## Description

The present invention relates to a semiconductor image sensor formed on a semiconductor substrate of the type including a plurality of semiconductor light detection cells and a CCD (charge-coupled device) connected thereto.

An image sensor having a one-dimensional array structure and provided with a CCD, which outputs the electrical signal produced in each of the light detection cells (referred to hereinafter as picture cells) of the image sensor, of 2K pixels (2048 cells) has already been used in practical applications. The total chip length of the array of picture cells is approximately 30 mm, of which 27 mm are for the picture cells. The pitch of the picture cells is thus 14 x 10⁻⁶m including 1.5 x 10⁻⁶m for field isolation between the picture cells. The operating voltage biasing the picture cells is usually 5 V, the same as that of a MOS transistor. However, the operating voltage of the CCD portion connected to the picture cells is usually 12 V due to the inherent requirement of the CCD.

This known semiconductor image sensor includes an insulation layer for isolating peripheral wirings of the CCD, such as aluminum buses and polycrystalline silicon wirings connected to charge-transfer electrodes of the CCD, from the semiconductor substrate, and a field isolation for isolating the neighbouring picture cells.

The thickness of the insulation layer is chosen to be adequate to withstand the voltage applied to the CCD. This means that the thickness of the insulation layers must be sufficient to prevent the voltage applied to the peripheral wirings to cause the field intensity in a p⁺ region of the substrate underneath the insulation layer to exceed a threshold level above which this p⁺ region is inverted causing an unexpected lateral conduction path therethrough and resulting in a degradation of the function of the device.

The fabrication step of the above-mentioned insulation layer and field isolation includes the forming over the semiconductor substrate of a silicon dioxide film having a thickness adequate for CCD transferring operation, therefore much thinner than the thickness of the insulation layer for the peripheral wirings or of the field isolation for the picture cells. Then the portion except that to be exposed for fabricating the insulation layer and field isolation is protected by a mask. The exposed portion is additionally oxidized by a thermal oxidation method until the exposed insulation film becomes thick enough to form the insulation layer of the peripheral portion of the CCD. During this additional oxidization, the width of the field isolation also expands laterally wider according to the amount of the thickness increase (i.e. height) of the insulation layer to be obtained.

As a result of their simultaneous forming, the insulation layer and field isolation have substantially the same thickness. Due to the fact that the thickness of the insulation layer is selected to be sufficient to withstand the voltage (12 V) applied to the CCD, the thickness of the field isolation for the picture cells is excessively larger than required for withstanding the voltage (5V) applied to the picture cells.

A detailed technical description of a classical device can be found in Transactions of the Institute of Electronics and Communications of Japan vol. E63, no. 12, December 1980, Tokyo JP; pages 855-862; T. Watanabe et al. : "CCD Linear Image Sensor with 2048 elements". In this prior art, the photoelements are MOS capacitor diodes measuring 14 x 14 microns and separated by channel stops beneath the field oxide in which they are formed. Data readout is effected by respective odd and even pixel CCD shift registers on either side of the photoelement line. The doping of the register barrier structure is optimised for maximum charge handling at a gate voltage of 12V.

Recently, a demand has appeared for image sensors of greater integration, such as 5K pixels, i.e. 5K cells, on a chip of unchanged size. To satisfy this demand, the pitch of the picture cells must be less than 7 x 10⁻⁶m. Accordingly, the width of the field insulation must also be reduced, in order to avoid reduction of the aperture ratio of the picture cells (ratio of the opened width of a picture cell to the cell pitch). If 2 x 10⁻⁶m is required for the width of the finished field isolation, its photo mask must have a width of 1 x 10⁻⁶m. Alignment of a mask having patterns of this size is very difficult.

It is therefore an object of the present invention to provide a semiconductor image sensor of the type defined at the beginning of this specification which has a greater density of integration, compared to the prior art, while showing a fair opening ratio of the picture cells, and which can be produced without much difficulty.

According to the present invention, the image sensor formed on a semiconductor substrate includes:
a plurality of semiconductor light detection cells formed on the semiconductor substrate, each of the light detection cells producing electrical signal charges representative of the intensity of a light injected thereto;
a charge-coupled device formed on the semiconductor substrate and operatively connected to the light detection cells for transferring and outputting electrical signal charges produced in the light detection cells;
a first insulation layer formed on the semiconductor substrate, for isolating a patterned wiring of a peripheral portion of the charge-coupled device from the semiconductor substrate; and
a second insulation layer formed on the semiconductor substrate for isolating adjacent ones of the light detection cells from one another, the thickness of the second insulation layer being thinner than the thickness of the first insulation layer.

A further object of the present invention is to provide a method for fabricating such an image sensor.

In one embodiment of the present invention, said method includes the steps of:
forming on the semiconductor substrate the first insulation layer made of silicon dioxide to isolate the patterned wiring of the peripheral portion of the charge-coupled device, the remaining surface of the semiconductor substrate being masked with a masking film;
forming a photo resist film covering the surface of the first insulation layer and masking film;
forming in the photo resist film and masking film an opening at a position where a field isolation for a light detection cell is to be formed;
doping the substrate with an impurity through the opening, so as to prepare a channel stop region;
removing the photo resist film
forming the second insulation layer made of silicon dioxide in the opening and upon the doped region of the substrate, the second insulation layer being essentially thinner than the first insulation layer; and removing the masking film.

In another embodiment, the method according to the invention includes the steps of:
forming an insulation layer made of silicon dioxide on a first portion of the substrate where the patterned wiring of the peripheral portion of the charge-coupled device is to be fabricated, and on a second portion of the substrate where the light detection cells of the image sensor are to be isolated from one another to form the second insulation layer, the remaining surface of the substrate being masked with a first masking film;
forming a second masking film covering the portion of the surface of the insulation layer formed on the second portion of the substrate surface;
forming an additional insulation layer upon said insulation layer, to obtain the first insulation layer with a thickness larger than that of the said second insulation layer; and
removing the first and second masking films.

The present invention will be more readily understood from the description of particular embodiments made hereinafter with reference to the accompanying drawings, wherein:
Figure 1 (a) is a schematic plan view of an embodiment of an image sensor according to the present invention;
Figure 1 (b) is a schematic cross-sectional side view along line a-a' of Figure 1 (a),
Figure 1 (c) is a schematic cross-sectional side view along line b-b' of Figure 1 (a);
Figure 2 through Figure 8 schematically illustrate main steps of an embodiment of the method according to the invention to produce an image sensor according to the present invention; and
Figure 9 through Figure 13 schematically illustrate main steps of another embodiment of the method according to the invention to produce an image sensor according to the present invention.

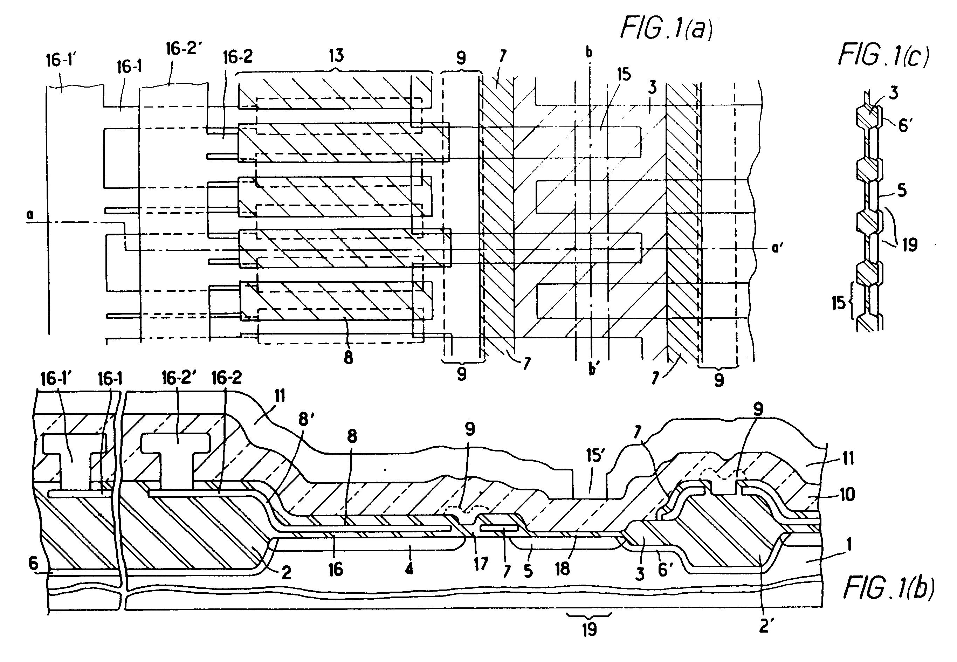

Referring to Figures 1 (a) through 1(c), the structure of an image sensor according to the present invention is hereinafter described.

The structure generally includes: an array of picture cells 19 for image sensing located along a centre line b-bʹ; a CCD 13 symmetrically arranged at both sides of line b-bʹ for transferring and outputting the signal charges produced in the picture cells; and main peripheral portions, such as 2-phase buses 16-1ʹ and 16-2ʹ and wirings 16-1 and 16-2 connected to charge-transfer electrodes 8 of the CCD 13, and symmetrically arranged outside of the charge transfer electrodes 8.

On a p⁻-type semiconductor substrate 1, an n-type region 5 is doped to form a p-n junction with the substrate. A photo gate 7 is formed in a SiO₂ insulation layer 17 by a silicon gate technique to hold the picture cells at a predetermined potential. Light injected through an opening 15ʹ of an aluminum coating 11, through a PSG (phospho silicate glass) passivation film 10 and through a window 15 of an SiO₂ layer film 18 into the p-n junction, produces signal charges in the p-n junction, depending on the intensity of the injected light. A picture cell 19 of the image sensor is thus constituted, as is well known.

The picture cells 19 are isolated from each other by field isolation 3 shown by hatched areas in Figs. 1 (a) and (c). As for its thickness, a detailed explanation will be given later. Underneath the field isolation 3, a p⁺-type region 6ʹ is formed as a channel stop to prevent lateral conduction path between the adjacent cells through the substrate 1, as well known. The signal charge produced by light injected in the n-type region 5 of the picture cell is transferred by a transfer gate 9 to a corresponding one of the charge transfer electrodes 8 of the CCD 13. Underneath each of the charge transfer electrodes 8, an n-type region 4 is formed for storing and transferring the signal charges. The arrays of charge transfer electrodes 8 of polycrystalline silicon together with the n-type region 4 form the CCD 13, as is well known.

In a peripheral portion of the CCD, the electrodes 8 comprise first electrodes (shown by solid lines) connected to a common patterned aluminum bus 16-1' through respective wirings 16-1 and second electrodes connected to a common patterned aluminum bus 16-2' through respective wirings 16-2. Each bus 16-1', 16-2' is formed on an insulation layer 2 of SiO₂, as well known. The patterned buses 16-1', 16-2' are supplied with 2-phase clock pulses φ₁ and φ₂, respectively, for charge transfer operation. The CCD portion is illustrated merely schematically in Figs.1, omitting the details.

The voltage supplied to the CCD portion is generally as high as 12 V, as inherently required for charge transfer operation. The insulation layer 2 is approximately 800 nm thick, enough to prevent the voltage (12 V) of the aluminum buses 16-1', 16-2' and polycrystalline silicon lead wirings 16-1, 16-2 to generate an undesired field effect onto the region 6 which must be inactive underneath the insulation layer 2. The transfer gate 9 is also supplied with a voltage of 12 V. At the location where the transfer gate 9 must exert its influence (i.e. field effect) on the substrate, for its charge transfer operation, the transfer gate 9 is located close to the substrate 1, whereas, at a portion where the transfer gate 9 must not exert its influence on the substrate, the transfer gate 9 is separated from the substrate 1 by a thick insulation layer 2' which is fabricated together with the insulation layer 2 and has the same thickness, as shown in Fig. 1(b).

The field isolation 3 has a thickness of approximately 300 to 400 nm, which is less than that of the insulation layer 2, and a width of approximately 2 x 10⁻⁶m or less, which can be achieved owing to its reduced thickness, because the width laterally inflates wider when the thickness is inflated by the thermal oxidization. The voltage applied to the picture cells as well as to the photo gate 7 is generally 5 V. Thus, the field isolation can be narrowed as long as the field isolation 3 can isolate the neighbouring picture cells. The narrowed width of the field isolation contributes to provide an adequate area for each picture cell, which means fair sensitivity of light detection, as well as a fair aperture ratio of the picture cells, as high as approximately 70%. The aperture ratio is essential for obtaining a more accurate information representative of the light intensity. Accurate information means information from a wider area of picture cell.

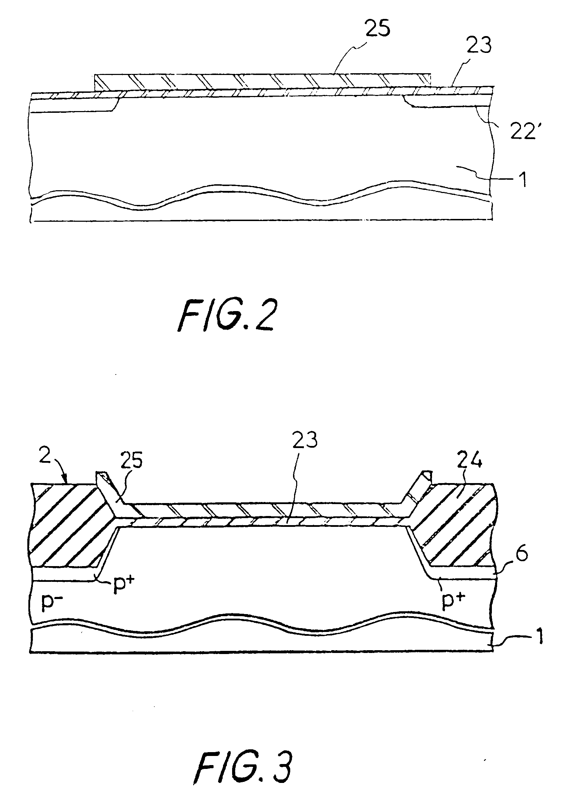

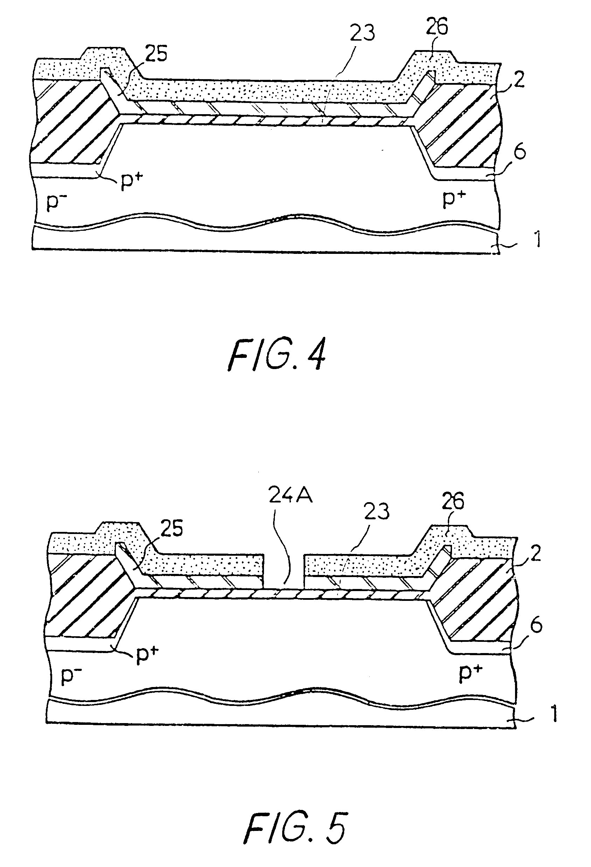

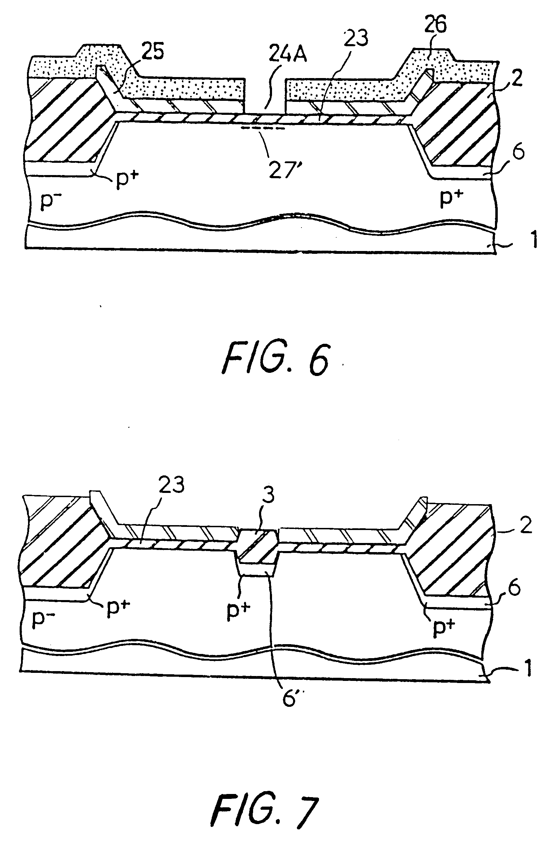

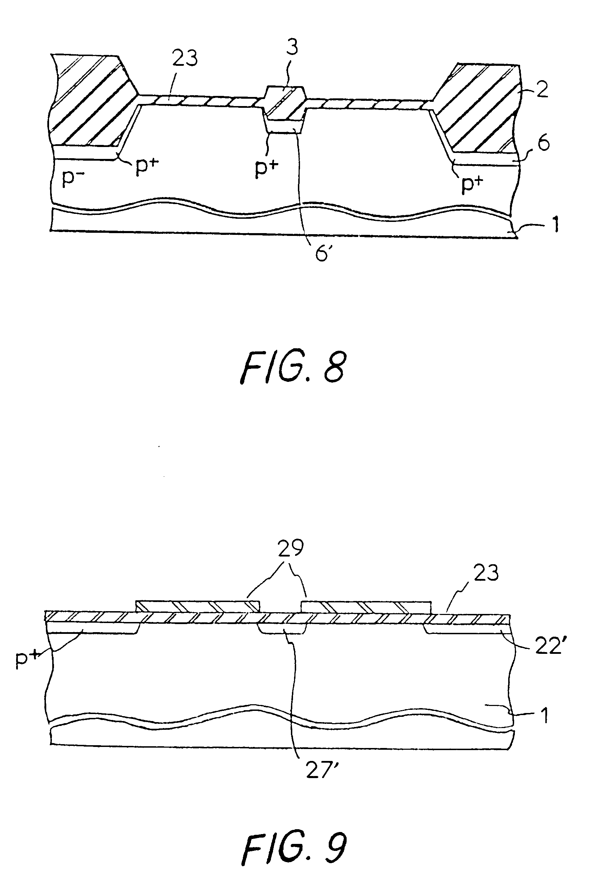

A first embodiment of a fabrication method of an image sensor according to the present invention is hereinafter described, referring to Fig. 2 through Fig.8. This method includes the following steps:
(1) On a portion where an insulation layer 2 of the peripheral portion is to be fabricated on a p⁻-type semiconductor substrate 1, a region 22ʹ is formed by p⁺-type impurity doping for preparing a channel stop 6, using a known method, such as ion implantation. An SiO₂ layer 23 as thick as approximately 100 nm is formed over the substrate 1, so as to cover all the surface, including the doped region 22ʹ, by a known method, such as thermal oxidization. The order of the above processes can be reversed.
(2) A silicon nitride (referred to hereinafter as Si₃N₄) film 25 is formed over the SiO₂ film 23, so as to cover the surface thereof except the area for fabricating the insulation layer 2 for the peripheral portion of the CCD (as shown in Fig.2). Film 25 is formed by employing known methods, such as CVD (chemical vapor deposition) and a photo lithography technique. The Si₃N₄ film 25 can be commonly used as a mask for the above-mentioned ion implantation.
(3) As shown in Fig.3, SiO₂ layers 24 having a thickness of approximately 700 nm are formed on the exposed portion of the SiO₂ layer 23, i.e. the portion not masked by the Si₃N₄ film 25, by a known method, such as selective oxidization method, or so called LOCOS (Local Oxidization of Silicon) method. Silicon inflates both vertically and laterally when it is oxidized, the surface then becomes taller and the p⁺ region 22ʹ is moved down deeper into the substrate. Thus, the insulation layer 2, formed by the SiO₂ layers 24, and its channel stop 6 are fabricated.
(4) A photo resist film 26 is formed all over the Si₃N₄ film 25 as well as over the inflated insulation layer 2, as shown in Fig.4.
(5) An opening 24A is formed in the photo resist film 26, on a portion where a field isolation for a picture cell is fabricated, by a known method, such as by a lithography technique. The portion of the Si₃N₄ film 25 exposed through the opening of the photo resist film is etched by a known method, such as a wet etching method, so that the opening 24A is made to expose the SiO₂ layer 23 therein, as shown in Fig. 5.
(6) The p⁻-type substrate 1 is doped by a p⁺-type dopant 27', such as boron, through the SiO₂ layer 23, by a known method, such as ion implantation, for preparing a channel stop 6', as shown in Fig.6.
(7) The photo resist film 26 is removed by a known method such as a stripping process. Then, the portion of the SiO₂ layer 23 exposed through the opening 24A is additionally oxidized by a known method, such as thermal oxidization, so that the SiO₂ in the opening 24A is inflated to be as thick as 300 nm to 400 nm, thus providing the field isolation 3 between consecutive picture cells, as shown in Fig.7. Then, the p⁺-type dopant 27' forms a channel stop region 6' underneath the fabricated field isolation 3.
(8) The Si₃N₄ film 25 used as an etching mask is removed, as shown in Fig.8.

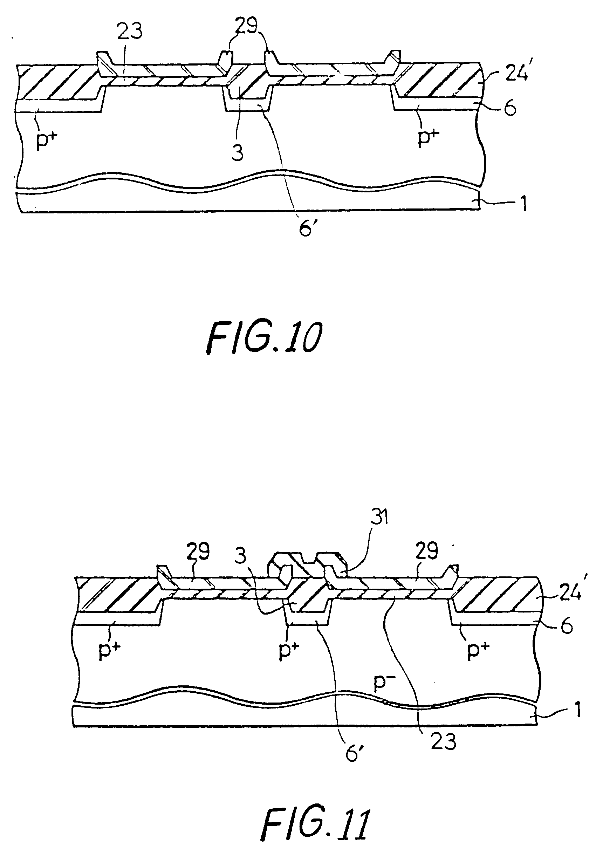

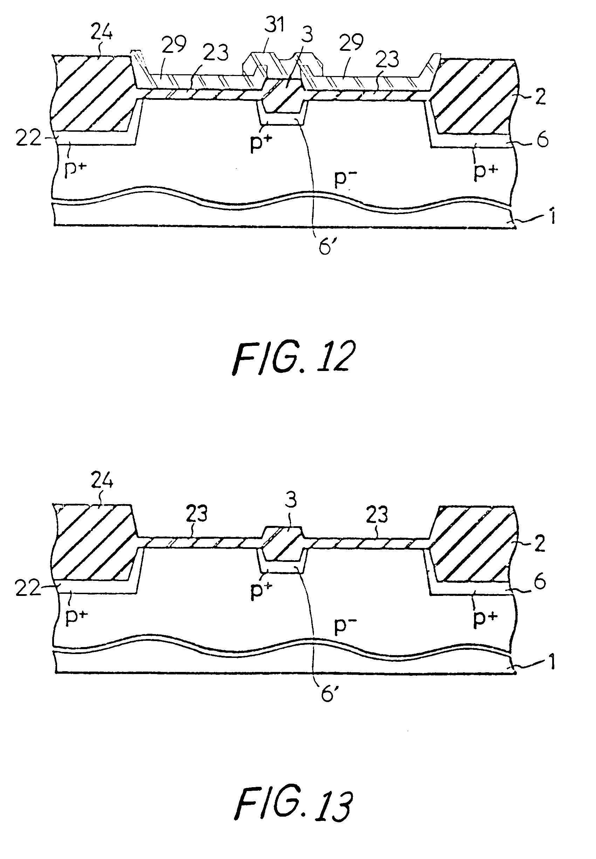

A second embodiment of the method according to the invention will now be explained, referring to Fig.9 through Fig.13. This method includes the following steps:
(1) Substrate 1 is selectively doped with p⁺-type impurity 22', 27', in portions where an insulation layer at the peripheral portion of CCD and a field isolation for picture cells are to be fabricated, to prepare channel stops 6,6', the doping being performed by a known method, such as ion implantation. An SiO₂ layer 23 as thick as approximately 100 nm is formed on the substrate 21, so as to cover all the surface including the doped regions 22ʹ and 27ʹ. Layer 23 is formed by a known method, such as thermal oxidization. The order of these processes can be reversed.
(2) As shown in Fig.9, a Si₃N₄ film 29 is formed over the SiO₂ layer 23ʹ, so as to cover the surface except the areas for fabricating the insulation layer 2 for the peripheral portion of the CCD and the field isolation 3 for the picture cells. Film 29 is formed by employing known methods, such as CVD and photo lithography technique. The Si₃N₄ film 29 can be commonly used as a mask for the above-mentioned ion implantation.
(3) As shown in Fig. 10, SiO₂ layers 24ʹ and 3 having a thickness of approximately 300 nm to 400 nm are formed on the exposed portions of the SiO₂ layer 23, i.e. the portions not masked by the Si₃N₄ film 29, by a known method, such as selective thermal oxidization, or so called LOCOS method, such as described with reference to Fig.3. Thus, the field isolation 3 is fabricated.
(4) A Si₃N₄ film 31 is formed to cover the field isolation 3, such as by CVD and photo lithography as shown in Fig.11.
(5) The exposed SiO₂ layer 24ʹ is further oxidized, using the Si₃N₄ films 29 and 31 as masks, by employing a known method, such as thermal oxidization method, until the exposed SiO₂ layer 24ʹ is inflated to become as thick as approximately 800 nm, thus providing the insulation layer 2.
(6) The Si₃N₄ film 29 and 31 used as masks are removed by a known method such as a stripping process. Insulation layers 2 and 3 of different thickness are thus formed as shown in Fig. 13.

Successive steps, such as forming silicon gates 7, electrodes 8, 8ʹ, transfer gates 9, wirings 16-1 and 16-2 and so on, following the step (8) of the first described embodiment or the step (6) of the second described embodiment are the same as in prior art processes for fabricating semiconductor image sensors. Therefore, description and drawings relative to said successive steps are omitted.

For the sake of simplification, the insulation layer 2ʹ on which the transfer gate 9 is formed, is omitted in the description referring to Figs. 2 to 9. The transfer gate 7 being supplied with a voltage of 12V, its thickness is the same as the one of the insulation layer 2 obtained from the SiO₂ layers 24.

The insulation layer 2, fabricated by the method according to the invention, is thick enough to withstand the applied voltage (12 V), while the field isolation 3 is thin and narrow enough to withstand the applied voltage (5 V). Thus, the width of the field isolation 3 can achieve less than a half of that of the prior art, resulting in a fair opening ratio, more than 70%, to be compared with about 50% if the prior art method for forming the insulation layer and field insulation were used). The fair value of the aperture ratio means accurate light information received by each picture cell. Consequently, according to the present invention, 5K-pixel image sensor having the same size as a prior art image sensor and outputting accurate light information is provided without any malfunction due to poor isolation of the cells or difficulty of production.

## Claims

1. An image sensor formed on a semiconductor substrate, including:
a plurality of semiconductor light detection cells (19) formed on the semiconductor substrate (1), each of the light detection cells producing electrical signal charges representative of the intensity of a light injected thereto;
a charge-coupled device (13) formed on the semiconductor substrate (1) and operatively connected to the light detection cells (19) for transferring and outputting electrical signal charges produced in the light detection cells;
a first insulation layer (2) formed on the semiconductor substrate (1), for isolating a patterned wiring (16-1, 16-2, 16'-1, 16'-2) of a peripheral portion of the charge-coupled device (13) from the semiconductor substrate; and
a second insulation layer (3) formed on the semiconductor substrate (1), for isolating adjacent ones of the light detection cells (19) from one another, the thickness of the second insulation layer (3) being thinner than the thickness of the first insulation layer (2).

2. An image sensor according to claim 1, characterized in that the thickness of the first insulation layer (2) is adequate to withstand a voltage applied to the patterned wiring (16-1, 16-2, 16'-1, 16'-2) of the peripheral portion of the charge-coupled device (13) and the thickness of the second insulation layer (3) is adequate to withstand a voltage applied to the light detection cells (19).

3. A method for fabricating an image sensor according to any one of claims 1 and 2, including the steps of:
forming on the semiconductor substrate (1) the first insulation layer (2) made of silicon dioxide to isolate the patterned wiring (16-1, 16-2, 16'-1, 16'-2) of the peripheral portion of the charge-coupled device (13), the remaining surface of the semiconductor substrate being masked with a masking film (25);
forming a photo resist film (26) covering the whole surface of the first insulation layer (2) and masking film (25);
forming in the photo resist film (26) and masking film (25) an opening (24A) at a position where a field isolation for a light detection cell is to be formed;
doping the substrate (1) with an impurity through the opening (24A), so as to prepare a channel stop region (6');
removing the photo resist film (26);
forming the second insulation layer (3) made of silicon dioxide in the opening (24A) and upon the doped region of the substrate, the second insulation layer (3) being thinner than the first insulation layer (2); and
removing the masking film (25).

4. A method for fabricating an image sensor according to any one of claims 1 and 2 including the steps of:
forming an insulation layer made of silicon dioxide on a first portion of the substrate (1) where the patterned wiring of the peripheral portion of the charge-coupled device is to be fabricated, and on a second portion of the substrate (1) where the light detection cells of the image sensor are to be isolated from one another to form the second insulation layer (3), the remaining surface of the substrate being masked with a first masking film (29);
forming a second masking film (31) covering the portion of the surface of the insulation layer formed on the second portion of the substrate surface;
forming an additional insulation layer upon said insulation layer, to obtain the first insulation layer (2) with a thickness larger than that of the said second insulation layer (3); and
removing the first and second masking films (29, 31).

5. A method according to claim 3, characterized in that the impurity doping is carried out by an ion implantation method.

6. A method according to any one of claims 3 to 5, characterized in that the forming of each insulation layer is carried out by a selective thermal oxidization method.

7. A method according to any one of claims 3 to 6, characterized in that each masking film (25; 29, 31) is made of silicon nitride.

## Patentansprüche

1. Bildsensor, der auf einem Halbleitersubstrat gebildet ist, mit:
einer Vielzahl von Halbleiter-Lichtdetektionszellen (19), die auf dem Halbleitersubstrat (1) gebildet sind, von welchen Lichtdetektionszellen eine jede elektrische Signalladungen erzeugt, die der Intensität des auf sie injizierten Lichtes entsprechen;
einer ladungsgekoppelten Anordnung (13), die auf dem Halbleitersubstrat (1) gebildet und betriebsfähig mit den Lichtdetektionszellen (19) verbunden ist, zum Übertragen und Abgeben elektrischer Signalladungen, die in den Lichtdetektionszellen erzeugt wurden;
einer ersten Isolierschicht (2), die auf dem Halbleitersubstrat (1) gebildet ist, zum Isolieren einer gemusterten Verdrahtung (16-1, 16-2, 16'-1, 16'-2) eines peripheren Abschnitts der ladungsgekoppelten Anordnung (13) vom Halbleitersubstrat; und
einer zweiten Isolierschicht (3), die auf dem Halbleitersubstrat (1) gebildet ist, um angrenzende Lichtdetektionszellen (19) voneinander zu isolieren, wobei die Dicke der zweiten Isolierschicht (3) dünner ist als die Dicke der ersten Isolierschicht (2).

2. Bildsensor nach Anspruch 1, dadurch gekennzeichnet, daß die Dicke der ersten Isolierschicht (2) ausreichend ist, eine Spannung auszuhalten, die an die gemusterte Verdrahtung (16-1, 16-2, 16 '-1, 16'-2) des peripheren Abschnitts der ladungsgekoppelten Anordnung (13) angelegt ist, und daß die Dicke der zweiten Isolierschicht (3) ausreichend ist, eine Spannung auszuhalten, die an die Lichtdetektionszellen (19) angelegt ist.

3. Verfahren zum Fertigen eines Bildsensors nach irgendeinem der Ansprüche 1 und 2, mit den Schritten:
Bilden der ersten Isolierschicht (2) aus Siliciumdioxid auf dem Halbleitersubstrat (1), um die gemusterte Verdrahtung (16-1, 16-2, 16'-1, 16'-2) des peripheren Abschnitts der ladungsgekoppelten Anordnung (13) zu isolieren, wobei die übrige Oberfläche des Halbleitersubstrates mit einem maskierenden Film (25) maskiert ist;
Bilden eines Photoresist-Films (26), der die gesamte Oberfläche der ersten Isolierschicht (2) und des maskierenden Films (25) abdeckt;
Bilden einer Öffnung (24A) im Photoresist-Film (26) und im maskierenden Film (25) an einer Position, wo eine Feldisolierung für eine Lichtdetektionszelle gebildet werden soll;
Dotieren des Substrates (1) mit einer Störstelle durch die Öffnung (24A), damit ein Kanalstopp-Bereich (6') hergestellt wird;
Entfernen des Photoresistfilms (26);
Bilden der zweiten Isolierschicht (3) aus Siliciumdioxid in der Öffnung (24A) und auf dem dotierten Bereich des Substrates, wobei die zweite Isolierschicht (3) dünner ist als die erste Isolierschicht (2); und
Entfernen des maskierenden Films (25).

4. Verfahren zum Fertigen eines Bildsensors nach irgendeinem der Ansprüche 1 und 2 mit den Schritten:
Bilden einer Isolierschicht aus Siliciumdioxid auf einem ersten Abschnitt des Substrates (1), wo die gemusterte Verdrahtung des peripheren Abschnitts der ladungsgekoppelten Anordnung gefertigt werden soll, und auf einem zweiten Abschnitt des Substrates (1), wo die Lichtdetektionszellen des Bildsensors voneinander isoliert werden sollen, um die zweite Isolierschicht (3) zu bilden, wobei die übrige Oberfläche des Substrates mit einem ersten maskierenden Film (29) maskiert ist;
Bilden eines zweiten maskierenden Films (31), der den Abschnitt der Oberfläche der Isolierschicht bedeckt, die auf dem zweiten Abschnitt der Substratoberfläche gebildet ist;
Bilden einer zusätzlichen Isolierschicht auf dieser Isolierschicht, um die erste Isolierschicht (2) mit einer Dicke zu erhalten, die größer ist als jene der zweiten Isolierschicht (3); und
Entfernen des ersten und zweiten maskierenden Films (29, 31).

5. Verfahren nach Anspruch 3, dadurch gekennzeichnet, daß das Störstellendotieren mittels eines Ionenimplantierungsverfahrens ausgeführt wird.

6. Verfahren nach irgendeinem der Ansprüche 3 bis 5, dadurch gekennzeichnet, daß das Bilden jeder Isolierschicht mittels eines selektiven thermischen Oxidationsverfahrens ausgeführt wird.

7. Verfahren nach irgendeinem der Ansprüche 3 bis 6, dadurch gekennzeichnet, daß jeder maskierende Film (25; 29, 31) aus Siliciumnitrid hergestellt wird.

## Revendications

1. Capteur d'image formé sur un substrat semiconducteur, comportant :
plusieurs cellules de détection de lumière semiconductrices (19) formées sur le substrat semiconducteur (1), chacune des cellules de détection de lumière produisant des charges de signal électriques représentatives de l'intensité de la lumière injectée dans celle-ci;
un dispositif à transfert de charge (13) formé sur le substrat semiconducteur (1) et fonctionnellement connecté aux cellules de détection de lumière (19), afin de transférer et de délivrer les charges de signal électriques produites dans les cellules de détection de lumière;
une première couche d'isolation (2) formée sur le substrat semiconducteur (1) servant à isoler un câblage, formé par tracé de motif (16-1, 16-2, 16'-1, 16'-2) et appartenant à une partie périphérique du dispositif à transfert de charge (13) vis-à-vis du substrat semiconducteur; et
une deuxième couche d'isolation (3) formée sur le substrat semiconducteur (1) et servant à isoler les unes des autres les cellules de détection de lumière (19) adjacentes, l'épaisseur de la deuxième couche d'isolation (3) étant inférieure à celle de la première couche d'isolation (2).

2. Capteur d'image selon la revendication 1, caractérisé en ce que l'épaisseur de la première couche d'isolation (2) convient pour supporter la tension appliquée au câblage, formé par tracé de motif, (16-1, 16-2, 16'-1, 16'-2) de la partie périphérique du dispositif à transfert de charge (13), et l'épaisseur de la deuxième couche d'isolation (3) convient pour supporter la tension appliquée aux cellules de détection de lumière (19).

3. Procédé de fabrication d'un capteur d'image selon l'une quelconque des revendications 1 et 2, comportant les opérations suivantes :
former sur le substrat semiconducteur (1) la première couche d'isolation (2), faite de dioxyde de silicium, afin d'isoler le câblage, formé par tracé de motif, (16-1, 16-2, 16'-1, 16'-2) appartenant à la partie périphérique du dispositif à transfert de charge (13), la surface restante du substrat semiconducteur étant masquée à l'aide d'une pellicule de masquage (25);
former une pellicule d'agent photosensible du type réserve (26), couvrant toute la surface de la première couche d'isolation (2) et de la pellicule de masquage (25);
former dans la pellicule d'agent photosensible (26) et la pellicule de masquage (25) une ouverture (24A) en une position où une isolation de champ destinée à une cellule de détection de lumière doit être formée;
doper le substrat (1) au moyen d'un impureté à travers l'ouverture (24A), de façon à préparer une région d'arrêt de canal (6');
retirer la pellicule d'agent photosensible (26);
former la deuxième couche d'isolation (3), faite de dioxyde de silicium, dans l'ouverture (24A) et sur la région dopée du substrat, la deuxième couche d'isolation (3) étant plus mince que la première couche d'isolation (2); et
retirer la pellicule de masquage (25).

4. Procédé de fabrication d'un capteur d'image selon l'une quelconque des revendications 1 et 2, comportant les opérations suivantes :
former une couche d'isolation, faite de dioxyde de silicium, sur une première partie du substrat (1), où le câblage, formé par tracé de motif, et appartenant à la partie périphérique du dispositif de transfert de charge doit être fabriqué et sur une deuxième partie du substrat (1) où les cellules de détection de lumière du capteur d'image doivent être isolées les unes des autres, de manière à former la deuxième couche d'isolation (3), la surface restante du substrat étant masquée à l'aide d'une première pellicule de masquage (29);
former une deuxième pellicule de masquage (31) couvrant la partie de la surface de la couche d'isolation formée sur la deuxième partie de la surface du substrat;
former une couche d'isolation supplémentaire sur ladite couche d'isolation, afin de donner à la première couche d'isolation (2) une épaisseur plus grande que celle de ladite deuxième couche d'isolation (3); et
retirer les première et deuxième pellicules de masquage (29,31).

5. Procédé selon la revendication 3, caractérisé en ce que l'opération d'introduction de l 'impureté de dopage s'effectue par un procédé d'implantation ionique.

6. Procédé selon l'une quelconque des revendications 3 à 5, caractérisé en ce que la formation de chaque couche d'isolation est réalisée par un procédé d'oxydation thermique sélective.

7. Procédé selon l'une quelconque des revendications 3 à 6, caractérisé en ce que chaque pellicule de masquage (25 ; 29, 31) est faite de nitrure de silicium.
